# EUROPEAN PATENT SPECIFICATION

(11) **EP 1 320 913 B1**
(45) Date of publication and mention of the grant of the patent: **31.03.2004**
(21) Application number: 01965537.2
(22) Date of filing: 19.09.2001
(51) Int. Cl.: H01S 3/23

(54) **HIGH-PEAK-POWER LASER DEVICE AND APPLICATION TO THE GENERATION OF LIGHT IN THE EXTREME ULTRAVIOLET**
LASER MIT HOHER SPITZENLEISTUNG UND DESSEN ANWENDUNG ZUR ERZEUGUNG VON LICHT IM EXTREM-UV-BEREICH
SYSTEME DE LASERS POSSEDANT UNE PUISSANCE DE CRETE ELEVEE ET SON UTILISATION POUR GENERER DE LA LUMIERE DANS L'ULTRAVIOLET EXTREME

(30) Priority: 27.09.2000 FR 0012286
(43) Date of publication of application: 25.06.2003
(73) Proprietor: Commissariat A L'Energie Atomique, 75752 Paris 15ème (FR)
(72) Inventor: WEULERSSE, Jean-Marc, F-91120 Palaiseau (FR); LE FLANCHEC, Vincent, F-75015 Paris (FR); GILBERT, Michel, F-91440 Bures sur Yvette (FR)
(74) Representative: Simonnet, Christine
(86) International application number: PCT/IB2001/001714
(87) International publication number: WO 2002/027872

(56) References cited:
- WO-A-94/26010
- FR-A- 2 798 781
- US-A- 4 953 950
- US-A- 5 009 658
- US-A- 5 048 027
- US-A- 5 488 619
- US-A- 5 838 709
- TICHENOR D A ET AL: "EUV engineering test stand" EMERGING LITHOGRAPHIC TECHNOLOGIES IV, SANTA CLARA, CA, USA, 28 FEB.-1 MARCH 2000, vol. 3997, pages 48-69, XP001010858 Proceedings of the SPIE - The International Society for Optical Engineering, 2000, SPIE-Int. Soc. Opt. Eng, USA ISSN: 0277-786X

## Description

### TECHNICAL FIELD

The present invention relates to a laser device of high peak power and of average power and of high repetition rate, while at the same time being of minimum cost and complexity.

The invention is applicable in particular to the generation of light in the extreme ultraviolet region.

Radiation belonging to this region, which is also called "EUV radiation", has wavelengths ranging from 8 nanometres to 25 nanometres.

The EUV radiation which can be obtained by making light pulses, generated with the device which is the subject of the invention, interact with a suitable target has numerous applications, especially in materials science, microscopy and most particularly in microlithography, in order to fabricate integrated circuits with a very high degree of integration. For this last application, it is particularly advantageous to have a high repetition rate, which is very difficult to obtain for high-peak-power lasers.

The invention is applicable to any field which requires an excitation laser of the same sort as those which are needed in microlithography.

### DESCRIPTION OF THE PRIOR ART

EUV lithography is needed in microelectronics in order to produce integrated circuits whose dimensions are less than 0.1 micrometres. Among the sources of EUV radiation, several such sources use a plasma generated by means of a laser.

To create such a plasma, it is necessary to have available a laser generating a high peak illumination. To this end, a pulsed laser is therefore used, delivering for example an energy of about 300 mJ per pulse or more.

Since the excitation wavelength does not play a very important role, it is indicated that from now on the invention will use for example YAG lasers, which lasers have undergone numerous developments in many industrial fields. However, other solid-state lasers, that is to say the amplifying medium of which is a solid, can be used in the present invention.

In order to obtain a very high energy stability shot by shot, it is known to use laser diode pumping.

In addition, in order to obtain the peak power needed for generating EUV radiation intended for photolithography, it is known to use pulsed diodes.

On this subject, reference may be made to the following document:
[1] Article by H. Rieger et al., "High brightness and power Nd:YAG laser", Advanced solid-state lasers, 1999, Boston MA, p. 49 to 53.
   This document discloses a device for photolithography, generating high peak-amplitude laser pulses at a relatively low repetition rate.
   Also, in order to obtain the required peak power, it is known to use an oscillator and amplifiers. The result thereof is a complex and expensive laser.
   On this subject, reference may be made to the following document:
[2] Article by G. Holleman et al., "Modeling high brightness kW solid-state lasers", SPIE Vol. 2989, p. 15 to 22.
   This document mentions two requirements of power lasers corresponding to two opposed technologies:
   on the one hand, applications of welding, machining or processing materials, which require lasers emitting long pulses, obtained by very simple technologies, and
   on the other hand, photolithography applications which require pulses which are short and, if possible, at a high rate, obtained by a very sophisticated and expensive technology using in particular two optical amplification stages.

   Reference may also be made to the following document, which aims to obtain a high-peak-power laser device:
[3] Article by G. Kubiak et al., "Scale-up of a cluster jet laser plasma source for Extreme Ultraviolet lithography", SPIE, Vol. 3676, 1999, p. 669 to 678.
   The device described in this document [3] uses YAG lasers pumped by pulsed diodes, as in the rest of the prior art relating to photolithography. In addition, it uses complex and expensive optical amplifiers. Furthermore, the intended repetition rate in this document [3] is 6 kHz, for an energy per pulse of 280 mJ.

### SUMMARY OF THE INVENTION

The aim of the present invention is to overcome these drawbacks by proposing a laser device which is capable of having a peak power which is at least as high, while having a higher repetition rate, and being less complex and less expensive than the known laser device mentioned above.

Specifically, the subject of the present inveption is a laser device comprising:
- at least three pulsed solid-state lasers, pumped by diodes operating continuously, intended to supply light pulses, and
- means for directing these light pulses substantially onto the same spot of a target and substantially at the same time onto this spot whereby the temporal offsets between the various elementary pulses respectively supplied by said solid-state lasers are small compared with the repetition period of said lasers.

According to a preferred embodiment of the device which is the subject of the invention, the lasers are mounted in oscillators, without amplifiers.

The device which is the subject of the invention comprises at least three pulsed lasers but, preferably, comprises more than three thereof.

According to a particular embodiment of the device which is the subject of the invention, this device in addition comprises means for modifying the spatial distribution of the light pulse resulting from the addition of light pulses supplied by the lasers.

According to another particular embodiment, the device in addition comprises means for controlling the lasers, which are capable of modifying the temporal distribution of the light pulse resulting from the addition of light pulses supplied by the lasers, so as to create composite pulses.

According to a particular embodiment of the invention, the profile of each composite pulse comprises a first pulse for igniting the plasma intended to be created by interaction of the light pulses with the target, a time interval where the energy is minimum while the plasma grows, then a second pulse, consisting of several elementary pulses, according to a sequence which depends on the plasma growth.

The device which is the subject of the invention may in addition comprise means for modifying the repetition rate of the light pulses emitted by the lasers or of the sequence of these light pulses emitted by the lasers.

In the case where composite pulses are created, the device which is the subject of the invention is preferably capable of directing a first highly-focused beam onto the target, then in applying the rest of the light energy to the target with a broader focus.

The lasers used in the invention are solid-state lasers, for example YAG lasers.

The target onto which the light pulses emitted by the lasers of the device which is the subject of the invention are directed may be provided to supply light in the extreme ultraviolet region by interaction with these light pulses.

However, the present invention is not limited to obtaining EUV radiation. It is applicable to any field where there is a need for high-peak-power laser beams, directed onto a target.

In the present invention, spatial superposition is used and, in a particular embodiment, temporal sequencing.

The term "spatial superposition" is taken to mean the superposition of a plurality of laser beams substantially onto the same spot of the target, substantially at the same time. The term "substantially at the same time" means that the temporal offsets between the various elementary pulses respectively supplied by the solid-state lasers of the laser device are small compared with the repetition period of these lasers. This superposition makes it possible to increase the energy per pulse and the peak powers.

As will be seen below, flexibility of use can be obtained with superposition of the laser beams on virtually the same spot and at virtually the same time. This flexibility of use makes it possible to optimize emission from the plasma created.

In the present invention, the four points (a) to (d) which follow are important.

### (a) Spatial superposition

This makes it possible to increase the peak power and to have considerable freedom to modify the spatial distribution of the light pulse which results from the addition of the elementary light pulses emitted by the lasers.

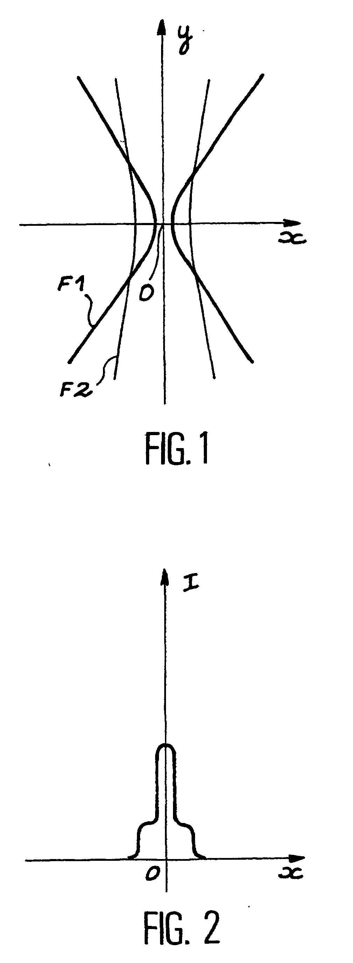

For example, the use of a light pulse more focused than the others, which use which is implemented in a preferred embodiment of the invention, makes it possible to obtain an illumination which is locally greater, as is shown schematically in Figures 1 and 2 where, for simplicity, only two beams are considered.

A first light beam F1 and a second light beam F2 are seen in section in Figure 1, in a plane which is defined by two perpendicular axes Ox and Oy, the axis common to the two beams being the Oy axis.

The two beams are substantially axisymmetric about this Oy axis and are focused in the vicinity of the point O, substantially in the plane of observation which is defined by the Oy axis and by an axis perpendicular to the Ox and Oy axes and which passes through the point O.

The focuses of the two beams are different, the first beam F1 being more focused than the second F2.

Figure 2 shows the variations in illumination I in the plane of observation as a function of the abscissa x plotted on the Ox axis.

Although beam F1 is five times more focused than the beam F2, the illumination produced by this beam F1 on the Oy axis is multiplied by 25 with respect to that produced by the beam F1 when the two beams have the same power. However, it should be noted that, in the present invention, it is possible to use beams whose powers are identical to or, in contrast, different.from one another or even very different from one another.

This "spatial superposition" of several beams on the same target at the same moment allows the offset, on a shorter timescale, of the instants of the pulses of each elementary laser.

### (b) Time sequencing of various laser pulses

### (b1) First mode:

When several lasers are focused on the same target, it is known to interleave in a substantially regular manner the emission of their pulses, which increases the repetition frequency without increasing the peak power.

### (b2) Second mode:

There is another possibility: to create bursts of pulses, in which the temporal offsets between two pulses of two elementary lasers are very small compared with the repetition time between two bursts. Such bursts may be considered as composite pulses.

In this second mode, it is also possible, by means of a temporal offset of the light pulses, to create a prepulse.

On this subject, reference may be made to the following document which mentions the possibility of creating a prepulse responsible for igniting the plasma:
[4] Article by M. Berglund et al., "Ultraviolet prepulse for enhanced X-ray emission and brightness from droplet-target laser plasma", Applied Physics Letters, Vol. 69, 1996, page 1683.

The invention still uses mode (b2), which it can, in a particular embodiment, use together with mode (b1). In this case, groups of lasers generating composite pulses in mode (b2) are defined, and several of these groups are then combined with mode (b1).

The invention therefore provides considerable flexibility in the sequencing of elementary light pulses, and in particular the sequencing (b2) hereinafter considered as advantageous.

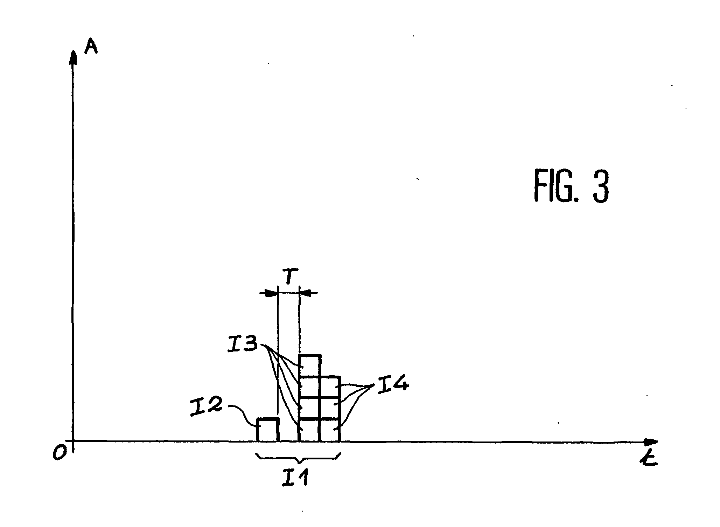

A first pulse highly focused onto the target (this pulse being for example of the type of beam F1 of Figure 1) ignites a plasma, then, during the time when the plasma grows, the target is subjected to a minimum or zero illumination, and when the plasma reaches the diameter of the beam F2, the target is subjected to the maximum light power. It is then advantageous to allocate less energy to the first pulse than that allocated to the rest of the composite pulse according to Figure 3.

In this Figure 3, the amplitudes A of the light pulses are shown as a function of time t. An example of a composite pulse I1 is shown. The latter comprises a prepulse I2 then a first set of simultaneous elementary pulses I3, separated from the prepulse by a time T needed for the plasma to grow, then a second set of simultaneous elementary pulses I4 which follow the first set.

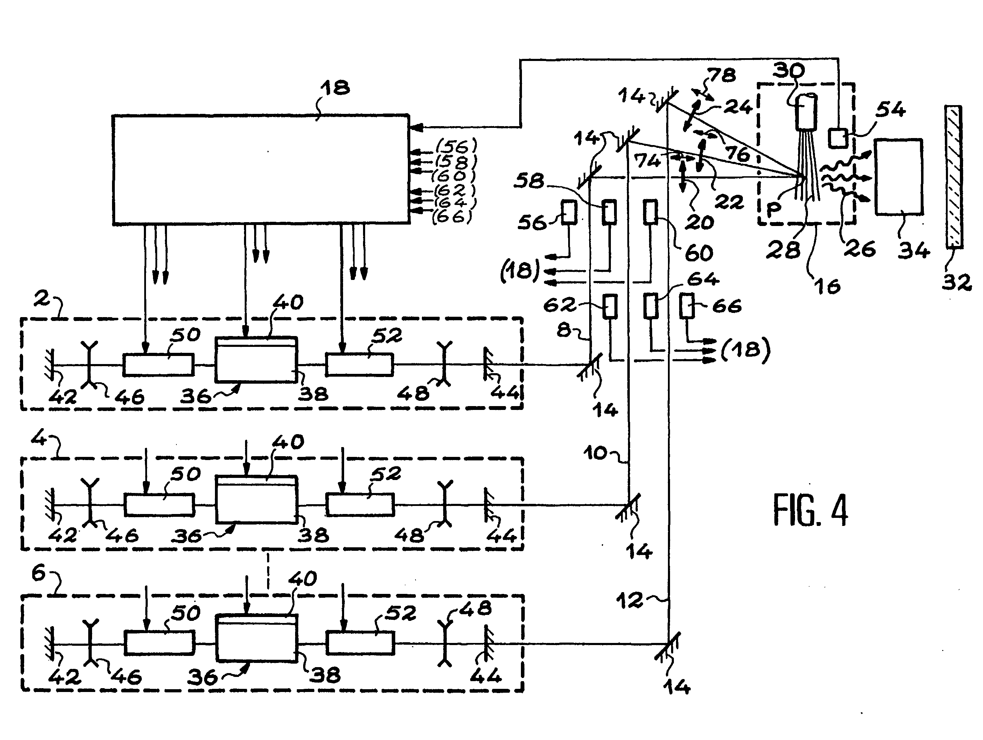

The invention also makes it possible to repeat this sequence at a high repetition frequency, many times that of the elementary lasers. It is possible to define groups of lasers, each one of which generates a burst or composite pulse, formed by a focused pulse and by one or more other pulses offset in time. Several of these groups may then be combined so as to interleave their composite pulses as is known for elementary pulses. The mounting of lasers of various groups is at any point identical to that of lasers of the same group. Only the trigger times generated by the means for controlling the lasers (means 18 of Figure 4) change.

### (c) Use of continuous diodes for pumping of the laser material

For a laser using a YAG material doped with neodymium and continuous pumping, the life of the upper level of the laser, which is in the vicinity of 250 microseconds, requires working at a rate greater than 5 kHz in order to properly extract the light power deposited.

### (d) Mounting of lasers in oscillators, without amplifiers

The present invention, unlike the prior art, intends to obtain high peak powers by combining the points unfavourable to this peak power (points c and d), and favourable points (point a).

Of course, points (b1), (c) and (d) are unfavourable to obtaining high peak powers but the use of points (a) and (b2) makes it possible to overcome this drawback.

In the present invention, points (a), (b2) and (c) are used simultaneously, and this combination of favourable and unfavourable points in obtaining high peak powers goes against the prior art. The preferred embodiment, founded on point (d), moves further away from the prior art.

Advantages of the present invention, apart from generating laser pulses of high power and of high rate, are mentioned below.

The cost of constant average-power diodes is considerably less when these diodes operate continuously.

In addition, a laser device according to the invention is much simpler than those of the prior art since this device does not use amplifiers placed in series.

The exploitation and the maintenance of this laser device are less expensive because of the smaller number of optical components used.

Placing several oscillators in parallel allows more flexibility of use.

The increase in the number of lasers also makes it possible for a device according to the invention to be less sensitive to an incident relating to the instantaneous performance of one of the lasers.

### BRIEF DESCRIPTION OF THE DRAWINGS

The present invention will be better understood on reading the description of embodiments given by way of purely indicative and in no way limiting example, with reference to the appended drawings in which:
- Figures 1 and 2 illustrate schematically the use of two laser beams focused differently in order to obtain considerable local illumination and have already been described, and
- Figure 3 illustrates schematically an example of a composite light pulse which can be used in the present invention and has already been described, and
- Figure 4 is a schematic view of a particular embodiment of the device which is the subject of the invention.

### DETAILED SUMMARY OF PARTICULAR EMBODIMENTS

The device according to the invention, which is schematically shown in Figure 4, comprises more than three pulsed lasers, for example eight, but only three of them are shown in this Figure 4 and have the references 2, 4 and 6 respectively.

The light beams 8, 10 and 12 (more exactly, the light pulses) which are respectively supplied by these pulsed lasers 2, 4 and 6, are directed, via a set of mirrors 14, substantially onto the same point P of a target 16 and substantially at the same time onto this point P.

Means 18 for controlling the lasers have also been shown, making it possible to obtain the light pulses.

Figure 4 also shows focusing means 20, 22 and 24 which are provided to focus the light beams 8, 10 and 12 respectively on the point P of the target 16.

In the example in question, the lasers and the target are chosen in order to supply, by interaction of the light beams with this target, EUV radiation 26. To do this, the target comprises for example a stream 28 of aggregates (for example of xenon) which come from a nozzle 30.

This EUV radiation 26 is used for example for the microlithography of an integrated circuit 32. The block 34 of Figure 4 symbolizes the various optical means serving to shape the EUV radiation before it reaches the integrated circuit 32.

The lasers 2, 4 and 6 are identical. Each of them comprises a YAG pumping structure 36, the aberration and the birefringence of which are small. This structure 36 comprises a rod laser 38 which is pumped by a set of laser diodes 40 operating continuously. However, it can be advantageous to choose a laser different from the others in order to create the first "prepulse" pulse.

Each laser is mounted in an oscillator, without light amplification.

Each laser is formed in a cavity delimited by a first highly-reflecting mirror 42 and by a second mirror 44 which is partly reflecting in order to allow the light beam generated by the laser to pass through.

This cavity is designed to allow this beam to have a small divergence, of between 1.2 and 10 times the diffraction limit, for a short cavity length, so as also to obtain light pulses of short duration, between 5 ns and 100 ns.

Two divergent lenses 46 and 48 are used, which are placed between the mirrors 42 and 44, on each side of the rod laser 38.

The distances between the optical components are adjusted so that the various lenses present in the cavity give the fundamental mode of the cavity a diameter 1.5 to 10 times smaller than the diameter of the amplifying rod or rod laser. For this adjustment, the thermal focuses are taken into account by a method known to the person skilled in the art.

The pumping structure 36 comprises for example a double head with homogeneous pumping and compensation for birefringence by rotating the polarization by 90°.

The diameter of the rod laser 38 may be between 3 mm and 6 mm.

These characteristics are useful in order not to damage the performance of the laser cavity, above all when the average power is high.

In order to make each laser provide pulses, triggering means are placed in the cavity of this laser, for example acousto-optic means.

In the example of Figure 4, two acousto-optic deflectors 50 and 52 are used, which are controlled by the control means 18 and placed in the space delimited by the divergent lenses 46 and 48 on each side of the rod laser 38.

These two acousto-optic deflectors 50 and 52 are used to block the cavity with corresponding gains at average powers of between 150 W and 600 W.

The control means 18 allow the EUV source to be varied and stabilized depending on the needs of the microlithography and the synchronization of the lasers 2, 4 and 6.

The repetition frequency is 10 kHz for each of the eight lasers since the latter form only a single group and since each pulse is a composite pulse, that is to say a pulse consisting of a prepulse followed by seven additional elementary pulses.

The control means 18 comprise means (not shown) for generating currents supplying pumping laser diodes 40 and means (not shown) for generating modulated radio frequency currents, intended to control each pair of acousto-optic deflectors 50 and 52.

Furthermore, these control means 18 are provided to control the lasers 2, 4 and 6 according to signals for measuring the radiation from the plasma (generated by interaction of the laser beams with the target 16), said signals being supplied by one or more suitable sensors such as on the sensor 54, for example one or more fast silicon photodiodes with spectral filtering; for EUV radiation, this filtering may be carried out by zirconium, and by a molybdenum-silicon multilayer mirror, possibly doubled; where the growth rate of the plasma is observed, it is worth either modifying this filtering, or adding one or more additional fast photodiodes whose filtering is closer to the visible spectrum.

The control means 18 are also provided to control the lasers 2, 4 and 6 according to
- signals for measuring the energy of the light pulses from lasers 2, 4 and 6, signals which are respectively supplied by suitable sensors 56, 58 and 60, for example fast silicon photodiodes with integrating means, and
- signals for measuring the temporal shapes of the light pulses from the lasers 2, 4 and 6, signals which are respectively supplied by three suitable sensors 62, 64 and 66, for example fast silicon photodiodes, which can be the same sensors as the sensors 56, 58, 60 except that the signal is then taken upstream of the integrating means.

It is specified that the optical means formed by the deflection mirrors 14 and the focusing lenses 20, 22 and 24 are chosen to allow spatial superposition with fluctuations of position which are less than a small percentage, for example of the order of 1% to 10%, of the diameter of the focal point (point P).

The laser device of Figure 4 furthermore comprises means provided to modify the spatial distribution of the pulse resulting from the addition of light pulses respectively emitted by lasers 2, 4 and 6. These means, symbolized by the arrows 74, 76 and 78, are for example provided in order to move the lenses 20, 22 and 24, so as to modify the sizes of the focal points respectively supplied by these lenses.

The control means 18 may be provided in order to temporally offset, each with respect to the others, the light pulses emitted by the lasers 2, 4 and 6, by suitably offsetting the triggering of the lasers each with respect to the others.

## Claims

1. Laser device comprising:
- at least three pulsed solid-state lasers (2, 4, 6), pumped by diodes (40) operating continuously, intended to supply light pulses, and
- means (14) for directing these light pulses substantially onto the same spot of a target (16) and substantially at the same time onto this spot, whereby the temporal offsets between the various elementary pulses respectively supplied by said solid-state lasers are small compared with the repetition period of these lasers.

2. Device according to Claim 1, in which the lasers pumped by diodes (40) operating continuously are mounted in oscillators, without amplifiers.

3. Device according to either of Claims 1 and 2, in addition comprising means (74, 76, 78) for modifying the spatial distribution of the light pulse resulting from the addition of light pulses supplied by the lasers.

4. Device according to any one of Claims 1 to 3, in addition comprising means (18) for controlling the lasers, which are capable of modifying the temporal distribution of the light pulse resulting from the addition of light pulses supplied by the lasers, so as to create composite pulses.

5. Device according to Claim 4, in which the profile of each composite pulse comprises a first pulse for igniting the plasma intended to be created by interaction of the light pulses with the target, a time interval where the energy is minimum while the plasma grows, then a second pulse, consisting of several elementary pulses, according to a sequence which depends on the plasma growth.

6. Device according to any one of Claims 1 to 5, in addition comprising means (18) for modifying the repetition rate of the light pulses emitted by the lasers or of the sequence of these light pulses emitted by the lasers.

7. Device according to either of Claims 4 and 5, capable of directing a first highly-focused beam (F1) onto the target, then in applying the rest of the light energy to the target with a broader focus.

8. Device according to any one of Claims 1 to 7, in which the lasers (2, 4, 6) are YAG lasers.

9. Device according to any one of Claims 1 to 8, in which the target (16) is provided in order to supply light in the extreme ultraviolet region by interaction with the light pulses emitted by the lasers (2, 4, 6).

## Patentansprüche

1. Laservorrichtung, die umfasst:
wenigstens drei gepulste Festkörperlaser (2, 4, 6), die durch kontinuierlich arbeitende Dioden (40) gepumpt werden und die zur Zuführung von Lichtimpulsen bestimmt sind, und
eine Einrichtung (14), die diese Lichtpulse im Wesentlichen auf den gleichen Punkt eines Targets (16) und im Wesentlichen zur gleichen Zeit auf diesen Punkt richtet, so dass die zeitlichen Verschiebungen zwischen den verschiedenen Elementarimpulsen, die jeweils durch die Festkörperlaser zugeführt werden, verglichen mit der Impulsperiode dieser Laser gering sind.

2. Vorrichtung nach Anspruch 1, wobei die durch kontinuierlich arbeitende Dioden (40) gepumpten Laser ohne Verstärker in Oszillatoren angebracht sind.

3. Vorrichtung nach Anspruch 1 und 2, die zusätzlich Einrichtungen (74, 76, 78) zur Modifizierung der räumlichen Verteilung des Lichtimpulses umfasst, die aus der Hinzufügung von Lichtimpulsen resultiert, die durch die Laser zugeführt werden.

4. Vorrichtung nach einem der Ansprüche 1 bis 3, die zusätzlich eine Einrichtung (18) zum Steuern der Laser umfasst, die in der Lage ist, die zeitliche Verteilung der Lichtimpulse zu modifizieren, die aus der Hinzufügung von Lichtimpulsen resultiert, die durch die Laser zugeführt werden, um so zusammengesetzte Impulse zu erzeugen.

5. Vorrichtung nach Anspruch 4, wobei das Profil jedes zusammengesetzten Impulses einen ersten Impuls zum Zünden des Plasmas, das durch Wechselwirkung der Lichtimpulse mit dem Target erzeugt werden soll, ein Zeitintervall, in dem die Energie minimal ist, während das Plasma zunimmt, und dann einen zweiten Impuls, der aus mehreren Elementarimpulsen besteht, entsprechend einer Sequenz umfasst, die von der Plasmazunahme abhängt.

6. Vorrichtung nach einem der Ansprüche 1 bis 5, die zusätzlich eine Einrichtung (18) zum Modifizieren der Impulsperiode der Lichtimpulse, die durch die Laser emittiert werden, oder der Abfolge dieser Lichtimpulse, die durch die Laser emittiert werden, umfasst.

7. Vorrichtung nach den Ansprüchen 4 und 5, die in der Lage ist, einen ersten stark fokussierten Strahl (F1) auf das Target zu richten und dann den Rest der Lichtenergie mit einem breiteren Fokus auf das Target einwirken zu lassen.

8. Vorrichtung nach einem der Ansprüche 1 bis 7, wobei die Laser (2, 4, 6) YAG-Laser sind.

9. Vorrichtung nach einem der Ansprüche 1 bis 8, wobei das Target (16) vorhanden ist, um durch Wechselwirkung, mit den Lichtimpulsen, die durch die Laser (2, 4, 6) emittiert werden, Licht im extremen Ultraviolettbereich zuzuführen.

## Revendications

1. Dispositif laser comprenant :
- au moins trois lasers à l'état solide pulsés (2, 4, 6), pompés par des diodes (40) fonctionnant en continu, destinés à délivrer des impulsions de lumière, et
- des moyens (14) pour diriger ces impulsions de lumière sensiblement sur le même point d'une cible (16) et sensiblement au même moment sur ce point, moyennant quoi les décalages temporels entre les diverses impulsions élémentaires respectivement délivrées par lesdits lasers à l'état solide sont faibles comparées à la période de répétition de ces lasers.

2. Dispositif selon la revendication 1, dans lequel les lasers pompés par des diodes (40) fonctionnant en continu sont montés en oscillateurs, sans amplificateurs.

3. Dispositif selon l'une quelconque des revendications 1 et 2, comprenant, de plus, des moyens (74, 76, 78) pour modifier la répartition spatiale de l'impulsion de lumière résultant de l'addition des impulsions de lumière délivrées par les lasers.

4. Dispositif selon l'une quelconque des revendications 1 à 3, comprenant, de plus, des moyens (18) pour commander les lasers, qui sont capables de modifier la répartition temporelle de l'impulsion de lumière résultant de l'addition des impulsions de lumière délivrées par les lasers, de manière à créer des impulsions composites.

5. Dispositif selon la revendication 4, dans lequel le profil de chaque impulsion composite comprend une première impulsion pour amorcer le plasma destiné à être créé par l'interaction des impulsions de lumière avec la cible, un intervalle de temps où l'énergie est minimum pendant que le plasma croît, et ensuite une deuxième impulsion, consistant en plusieurs impulsions élémentaires, selon une séquence qui est fonction de la croissance du plasma.

6. Dispositif selon l'une quelconque des revendications 1 à 5, comprenant, de plus, des moyens (18) pour modifier la cadence de récurrence des impulsions de lumière émises par les lasers ou de la séquence de ces impulsions de lumière émises par les lasers.

7. Dispositif selon l'une quelconque des revendications 4 et 5, capable de diriger un premier faisceau fortement focalisé (F1) sur la cible, et d'appliquer ensuite le reste de l'énergie lumineuse à la cible avec une focalisation plus large.

8. Dispositif selon l'une quelconque des revendications 1 à 7, dans lequel les lasers (2, 4, 6) sont des lasers YAG.

9. Dispositif selon l'une quelconque des revendications 1 à 8, dans lequel la cible (16) est prévue pour délivrer une lumière dans le domaine extrême ultraviolet par interaction avec les impulsions de lumière émises par les lasers (2, 4, 6).
